Europäisches Patentamt

European Patent Office

Office européen des brevets

(19)

(11) EP 0 665 309 B1

(12) **EUROPÄISCHE PATENTSCHRIFT**

| | |
|---|---|
| (45) Veröffentlichungstag und Bekanntmachung des Hinweises auf die Patenterteilung:<br>**04.02.1998 Patentblatt 1998/06** | (51) Int Cl.⁶: **C23F 1/18**, C23F 1/46 |

(21) Anmeldenummer: **95101277.2**

(22) Anmeldetag: **30.01.1995**

(54) **Verfahren zum Abtragen von Kupfer**

Copper etching process

Procédé de décapage de cuivre

(84) Benannte Vertragsstaaten:
**DE ES GB IT**

(30) Priorität: **31.01.1994 DE 4402788**

(43) Veröffentlichungstag der Anmeldung:
**02.08.1995 Patentblatt 1995/31**

(73) Patentinhaber: **Emil Krechen
Industrievertretungen GmbH
D-42655 Solingen (DE)**

(72) Erfinder:
• **Decker, Günter
D-42655 Solingen (DE)**
• **Der andere Erfinder hat auf seine Nennung
verzichtet**

(74) Vertreter: **Dipl.-Phys.Dr. Manitz
Dipl.-Ing. Finsterwald Dipl.-Ing. Grämkow
Dipl.-Chem.Dr. Heyn Dipl.-Phys. Rotermund
Morgan B.Sc.(Phys.)
Robert-Koch-Strasse 1
80538 München (DE)**

(56) Entgegenhaltungen:
EP-A- 0 138 531   DE-A- 2 358 683
DE-A- 3 046 477   FR-A- 1 570 970
FR-A- 2 392 100   GB-A- 1 141 407
US-A- 3 476 624   US-A- 3 779 842
US-A- 4 462 861

• PATENT ABSTRACTS OF JAPAN vol. 003 no.
032 (C-040) ,17.März 1979 & JP-A-54 009130
(TOSHIBA CORP) 23.Januar 1979,

**Beschreibung**

Die Erfindung betrifft ein Ätzverfahren zum Abtragen von Kupfer von Zinn- oder Zinn/Blei-plattierten Leiterplatten, bei welchem das abzutragende Kupfer mit einem Oxidationsmittel oxidiert und das Kupferoxid durch eine Phosphorsäurelösung abgelöst wird.

Zur Herstellung von Leiterplatten sind verschiedene Verfahren bekannt.

Bei einem Verfahren (Tenting) wird auf eine kupferkaschierte Grundplatte, beispielsweise aus Epoxidharz, nach dem Durchkontaktieren eine durchgängige Kupferschicht aufgetragen, welche anschließend mit einer photoempfindlichen Schicht belegt wird. Die photoempfindliche Schicht besteht aus einem Material, das sich bei Belichtung derart verändert, daß es gegen nachfolgende chemische Prozeßschritte resistent ist (Resist), während die nicht belichtete Schicht mit einer Lösung auswaschbar ist. Durch Auflegen einer Maske auf die photoempfindliche Schicht und anschließendes Belichten können diejenigen Bereiche der photoempfindlichen Schicht widerstandsfähig gemacht werden, die als Leiterbahnen auf der Leiterplatte verbleiben sollen. Die nicht belichteten Schichten können abgelöst und das sich unter diesen befindende Kupfer anschließend weggeätzt werden, so daß nur noch die gewünschten Leiterbahnen als Kupferschicht auf der Grundplatte verbleiben.

Bei einem anderen Verfahren zur Herstellung von Leiterplatten wird auf eine kupferkaschierte Grundplatte beim Durchkontaktieren nur eine sehr dünne Kupferschicht aufgebracht und diese mit einer lichtempfindlichen Schicht belegt. Bei diesem Verfahren bleiben nun bei der anschließenden Belichtung diejenigen Stellen der lichtempfindlichen Schicht unbelichtet, an denen eine Leiterbahn entstehen soll. Dort, wo keine Leiterbahnen vorhanden sein sollen, findet also eine Belichtung statt. An den unbelichteten Stellen wird die lichtempfindliche Schicht entfernt und die darunter befindliche dünne Kupferschicht freigelegt. Anschließend wird an diesen Stellen soviel Kupfer elektrolytisch abgeschieden, wie zum Aufbau der gewünschten Leiterbahnen erforderlich ist.

Nachfolgend wird auf diese Kupferleiterbahnen z. B. eine Zinn- oder Zinn/Bleilegierung elektrolytisch abgeschieden. Diese Zinn- oder Zinn-Blei-Schicht bildet eine sogenannte Ätzreserve beim anschließenden Wegätzen der unter der belichteten lichtempfindlichen Schicht (Resist) liegenden dünnen Kupferschicht an den Stellen, an denen keine Leiterbahnen aufgebaut wurden. Die belichtete lichtempfindliche Schicht wird hierbei zuvor durch Strippen beispielsweise mit Kalilauge entfernt.

Das Wegätzen der Kupferschichten erfolgt bisher bei den genannten Aufbauverfahren mittels eines ammoniakalischen Ätzmediums, was eine Reihe von Nachteilen mit sich bringt. So ist dieses Ätzmedium insbesondere giftig und schwer recyclebar. Allein der Transport des in großen Mengen benötigten Ätzmediums und des verbrauchten Ätzmediums stellt eine erhebliche Umweltgefährdung dar. Außerdem entsteht beim Recyclen dieses Ätzmediums unter anderem Nitrat, welches entsorgt werden muß.

Die Verwendung eines ammoniakalischen Ätzmediums hat außerdem den Nachteil, daß Probleme bei Verwendung von alkali-entwickelbaren Resisten auftreten. Die Verwendung solcher Resiste wird aber aus Umweltgründen gefordert. Außerdem kann ein Laminat (beispielsweise Innenlagen) nicht ein zweites Mal mit diesem Ätzmedium behandelt werden, da sich dann in der Regel der Resist löst und das zu schützende Kupfer weggeätzt wird.

Es sind zwar andere Ätzmedien zum Abtragen von Kupfer bekannt, beispielsweise Eisen-III-Chlorid und Kupferchlorid. Diese Ätzmedien greifen jedoch Zinn/Blei an und sind daher nicht für mit Zinn/Blei-Ätzreserve arbeitende Leiterplattenherstellungsverfahren verwendbar.

Aus der US-PS 3,779,842 ist ein Ätzmittel für Kupfer bekannt, welches Peroxophosphate und eine Säure wie Phosphorsäure enthält.

Aus der Druckschrift DE 30 46 477 A1 und FR-A-2 392 100 sind Verfahren zum Ätzen von Metalloberflächen bekannt, bei welchen das Metall auf der Schaltung mittels einer Phosphorsäure und Wasserstoffperoxid enthaltenden Lösung abgeätzt wird. Das Wasserstoffperoxid dient dabei zum Oxidieren des abzutragenden Metalls, während die Phosphorsäure anschliessend das oxidierte Metall ablöst. Bei diesem bekannten Verfahren nach DE 3046477 wird der Ätzlösung vor jedem Aufbringen oder bei jedem Aufbringen soviel Wasserstoffperoxid zugegeben, wie für den jeweiligen Ätzvorgang nötig ist.

Ein Nachteil dieser bekannten Verfahrens besteht darin, daß Wasserstoffperoxid relativ teuer ist und ebenfalls Transportprobleme vorhanden sind. Zudem wird durch das dauernde Zugeben von Wasserstoffperoxid zur Ätzlösung, welches sich beim Oxidieren des Kupfers in Wasser umwandelt, die Ätzlösung dauernd verdünnt. Dies führt zu einer steten Erhöhung der Menge an Ätzlösung, was ein Entsorgen der Überschußmenge erforderlich macht.

Aus der DE-A-23 58 683 ist es bekannt, verbrauchtes Wasserstoffperoxid durch Zugabe von Ozon nachzuliefern. Damit entfällt der Transport von Wasserstoffperoxid.

Es ist daher Aufgabe der Erfindung, ein Verfahren zum Abtragen von Kupfer von Zinn- oder Zinn/Blei-plattierten Leiterplatten anzugeben, welches diese Nachteile nicht aufweist, insbesondere nicht umweltgefährlich ist und ein problemloses Recyclen zuläßt.

Diese Aufgabe wird bei einem Verfahren der eingangs genannten Art dadurch gelöst, daß Peroxophosphorsäure als Oxidationsmittel verwendet wird und dadurch nachgeliefert wird, daß wenigstens von Zeit zu Zeit durch anodische Oxidation zumindest ein Teil der Phosphorsäure in der Ätzlösung in Peroxophosphorsäure umgewandelt wird.

Durch die von Zeit zu Zeit erfolgende anodische Oxidation der in der Ätzlösung vorhandenen Phosphorsäure zu Peroxophosphorsäure wird die Ätzlösung für eine nachfolgende Oxidation von Kupfer wieder aufbereitet, ohne daß die Gesamtmenge des Ätzmittels erhöht wird. Eine dauernde Entsorgung von überschüssigem Ätzmittel ist daher nicht notwendig.

Durch das Oxidieren des Kupfers wird dieses so umgewandelt, daß es von der Phosphorsäure angreifbar ist, d. h. die Phosphorsäure löst das Kupferoxid unter Bildung von Kupferphosphat und Wasser. Eine Reaktionsgleichung könnte daher beispielsweise folgendermaßen aussehen:

$$3CuO + 2H_3PO_4 \rightarrow Cu_3(PO_4)_2 + 3H_2O.$$

Peroxophosphorsäure hat den Vorteil, daß sie Blei und Zinn nicht angreift, die Ätzreserve also erhalten bleibt und nur das abzutragende Kupfer abgetragen wird. Eine Reaktionsgleichung könnte beispielsweise folgendermaßen aussehen:

$$Cu + H_3PO_5 \rightarrow CuO + H_3PO_4.$$

Die Erfindung setzt also voraus, daß in dem Ätzmedium Phosphorsäure der Oxidationsstufe +V enthalten ist. Zur Nachlieferung von Oxidationsmittel wird Phosphorsäure der Oxidationsstufe +V in der Ätzlösung anodisch oxidiert, so daß Peroxophosphorsäure gebildet wird. Diese ist, wie bereits ausgeführt, zur Oxidation des abzutragenden Kupfers besonders geeignet. Außerdem wird durch Verwendung von Phosphorsäure der Oxidationsstufe +V im Ätzmedium und anodisches Aufoxidieren dieser Phosphorsäure zu Peroxophosphorsäure bei verbrauchtem Ätzmedium ein praktisch vollständig geschlossener Kreislauf des Ätzmediums ermöglicht. Ein Transport von großen Mengen von Ätzmedium zum Ersatz von gebrauchtem Ätzmedium und ein Entsorgen des verbrauchten Ätzmediums entfallen dadurch. Die Reaktionsgleichung für die anodische Oxidation hat beispielsweise folgendes Aussehen:

$$2H_3PO_4 + O_2 \rightarrow 2H_3PO_5.$$

Als Phosphorsäure der Oxidationsstufe +V kann z. B. Ortho-, Meta- und Polyphosphorsäure verwendet werden.

Das auf diese Weise abgetragene Kupfer wird bevorzugt durch Elektrolyse von Zeit zu Zeit aus der Phosphorsäurelösung entfernt. Auf diese Weise kann einerseits das Metall rückgewonnen werden und andererseits die Phosphorsäurelösung für spätere Ätzvorgänge wieder aktiviert werden. Die Reaktionsgleichung für die Elektrolyse kann dabei folgendermaßen aussehen:

$$6H_2O + Cu_3(PO_4)_2 \rightarrow 3Cu + 2PO_4^{3-} + 6OH^- +$$

$$6H^+ \rightarrow 2H_3PO_4 + 3H_2O + 1,5O_2.$$

Die Verwendung von Peroxophosphorsäure als Oxidationsmittel hat auch den Vorteil, daß sie bei der Durchführung des erfindungsgemäßen Verfahrens nur in der Menge erzeugt werden muß, wie sie für die nachfolgende Oxidation des Kupfers benötigt wird. Die für die Wiedergewinnung des Kupfers aus der Ätzlösung durch Elektrolyse aufzuwendende Energiemenge kann dadurch gering gehalten werden.

Zur Elektrolyse des Kupfers wird bevorzugt eine Inertanode, insbesondere eine Platinanode oder eine platinierte Anode, verwendet, um vorteilhafterweise ein Auflösen oder Passivieren der Anode bei der Elektrolyse zu vermeiden. Die Elektrolyse erfolgt bevorzugt bei einer Stromdichte zwischen 0,5 und 4 A/cm$^2$.

Das erfindungsgemäße Verfahren kann bevorzugt in einem Kreisprozess durchgeführt werden, der folgende Schritte umfaßt:

In einem ersten Schritt wird das abzutragende Kupfer mit einer Lösung aus Peroxophosphorsäure, Phosphorsäure der Oxidationstufe +V und Wasser behandelt. In einem nächsten Schritt, der nur nach Bedarf erfolgen muß, also wenn das Ätzmedium verbraucht ist, wird das abgetragene Kupfer zumindest teilweise durch Elektrolyse mit einer Platinanode oder platinierten Anode aus der Ätzlösung herausgeholt und schließlich wird in einem dritten, ebenfalls nach Bedarf, also bei verbrauchtem Ätzmedium, durchgeführten Schritt die Phosphorsäure durch anodische Oxidation zu Peroxophosphorsäure aufoxidiert. Auf diese Weise wird das abgetragene Kupfer rückgewonnen und die Ätzlösung wieder aktiviert, wobei die neu gebildete Peroxophosphorsäure wieder als Oxidationsmittel dient, welche dann nachfolgend durch erneute anodische Oxidation der beim Ablösen des Metalloxids gebildeten Phosphorsäure der Oxidationsstufe +V stets nachgeliefert wird.

Das erfindungsgemäße Verfahren kann selbstverständlich auch dann verwendet werden, wenn an dem das abzutragende Kupfer aufweisenden Gegenstand weder Blei noch Zinn vorhanden ist, beispielsweise bei dem zuerst beschriebenen Herstellungsverfahren für Leiterplatten, sowie zum Anätzen von Leiterplatten als sogenannte Mikroätze.

Die Herstellung der Leiterplatten ist in der Zeichnung dargestellt und wird nachfolgend beschrieben. Es zeigen:

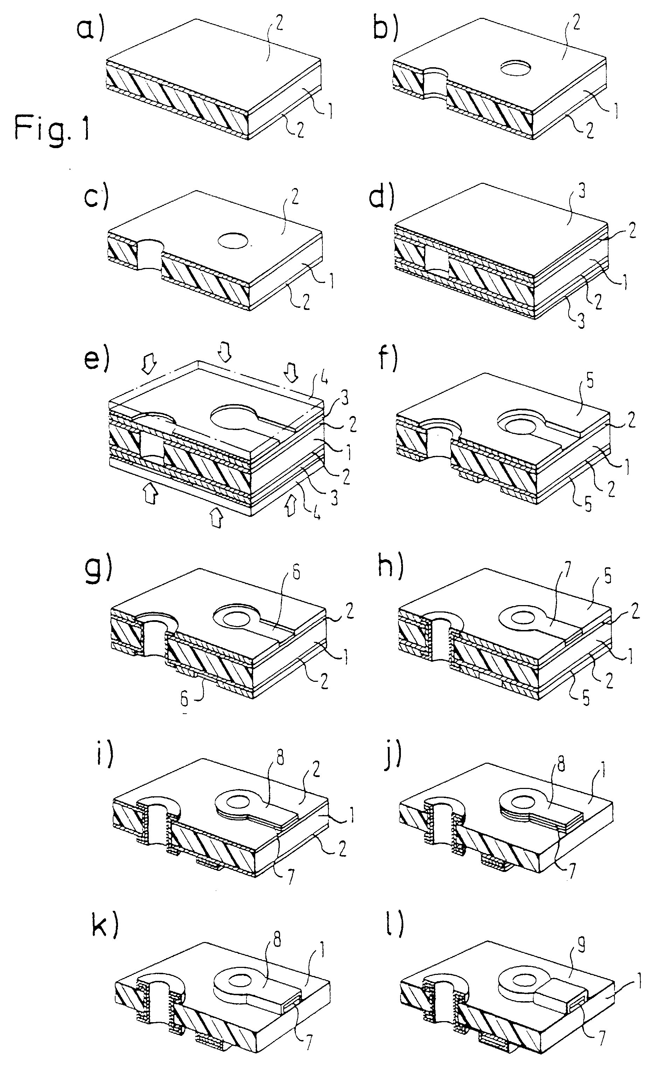

Figur 1 a bis 1    je einen Querschnitt durch einen Teil einer Leiterplatte in verschiedenen Herstellungsphasen.

Wie in Figur 1 schematisch dargestellt, wird zur Herstellung von Leiterplatten gemäß Figur 1 a ein Basismaterial 1, beispielsweise aus Epoxidharz, beidseitig mit Kupfer kaschiert, d. h. eine beispielsweise 17 µm dicke Kupferschicht 2 wird beidseitig auf das Basismaterial laminiert. Anschließend wird das kaschierte Basismaterial wie in Figur 1 b und c gezeigt, durchbohrt und stromlos verkupfert.

Nun wird, wie Figur 1 d zeigt, die Leiterplatte beidseitig mit einer lichtempfindlichen Schicht 3, einem sogenannten Resist, beschichtet und diese anschließend gemäß Figur 1 e durch aufgelegte Photomasken 4 belichtet und die belichteten Stellen gegen nachfolgende chemische Behandlungsschritte resistent gemacht.

An den nicht belichteten Stellen wird die lichtempfindliche Schicht 3 entfernt (Figur 1f) und an den dadurch freigelegten Stellen 6 der dünnen Kupferschicht 2 gemäß Figur 1g weiteres Kupfer elektrolytisch aufgebracht. Nachdem ausreichend Kupfer zur Bildung der Leiterbahnen 7 an diesen Stellen abgeschieden ist, wird gemäß Figur 1h ebenfalls elektrolytisch auf die Kupferleiterbahnen z.B. Zinn oder Zinn/Blei aufgetragen.

Nun wird gemäß Figur 1i der außerhalb der Leiterbahnen vorhandene Resist 5 beispielsweise mit Kalilauge gestrippt, so daß die darunterliegende Kupferschicht 2 freigelegt wird. Diese dünne Kupferschicht 2 wird nun gemäß Figur 1j durch Anwenden des erfindungsgemäßen Ätzmediums weggeätzt, wobei das Kupfer der Leiterbahnen 7 durch das darüberliegende, von dem erfindungsgemäßen Ätzmedium nicht angegriffene Zinn oder Zinn/Blei als Ätzreserve 8 geschützt wird. Auf der Leiterplatte verbleiben also lediglich die Leiterbahnen 7.

Abschließend wird das elektrolytisch auf den Kupferleiterbahnen 7 abgeschiedene Zinn oder Zinn/Blei 8 entweder gemäß Figur 1k umgeschmolzen, um zum Anschluß von elektrischen Bauteilen zu dienen, oder das Zinn oder Zinn/Blei 8 der Leiterplatte wird gestrippt und gemäß Figur 1l mit einer Lötstopmaske 9 versehen, um nur die gewünschten Kontaktierungen freizulassen, die mit einem Lötdepot (z.B. durch Heißverzinnen) versehen werden.

Das verwendete Ätzmedium besteht bevorzugt aus einer Lösung aus Phosphorsäure der Oxidationsstufe +V und Peroxophosphorsäure als Oxidationsmittel. Zur Nachlieferung von Oxidationsmittel wird die Phosphorsäure der Oxidationsstufe +V anodisch zu Peroxophosphorsäure aufoxidiert.

Der Gehalt der Phosphorsäure in dem Ätzmedium zu Beginn des Ätzens beträgt 10 bis 30%, bevorzugt ca. 20%. Das Abtragen des Kupfers erfolgt bevorzugt bei einer Temperatur zwischen 40 und 50°C, insbesondere bei ca. 45°C. Mit diesen Werten konnte ein Abtrag von 35µm im Tauchprozeß in zwei Minuten erzielt werden. Eine weitere Erhöhung der Abtragrate ist durch Temperaturerhöhung ohne weiteres möglich, wobei eine Temperaturerhöhung um 10°C ca. eine Verdoppelung der Abtragrate bewirkt.

Eine weitere Verwendung des erfindungsgemäßen Verfahrens besteht im Anätzen von Leiterplatten als sogenannte Mikroätze.

## Patentansprüche

1. Verfahren zum Abtragen von Kupfer von Zinn- oder Zinn/Blei-plattierten Leiterplatten, bei welchem das abzutragende Kupfer mit einem Oxidationsmittel oxidiert und das Kupferoxid durch eine Phosphorsäurelösung abgelöst wird, dadurch **gekennzeichnet**, daß Peroxophosphorsäure als Oxidationsmittel verwendet wird und dadurch nachgeliefert wird, daß wenigstens von Zeit zu Zeit durch anodische Oxidation zumindest ein Teil der Phosphorsäure in der Ätzlösung in Peroxophosphorsäure umgewandelt wird.

2. Verfahren nach Anspruch 1, dadurch **gekennzeichnet**, daß metallisches Kupfer durch Elektrolyse aus der Abtraglösung zurückgewonnen wird.

3. Verfahren nach Anspruch 2, dadurch **gekennzeichnet**, daß zur Elektrolyse des Kupfers eine Inertanode verwendet wird.

4. Verfahren nach Anspruch 3, dadurch **gekennzeichnet**, daß die Elektrolyse bei einer Stromdichte zwischen 0,5 und 4 A/cm$^2$ durchgeführt wird.

5. Verfahren nach einem der vorhergehenden Ansprüche, dadurch **gekennzeichnet**, daß ein Kreisprozeß durchgeführt wird, in dem in einem ersten Schritt das abzutragende Kupfer mit einer Lösung aus Peroxophosphorsäure, Phosphorsäure der Oxidationsstufe +V und Wasser behandelt wird, in einem zumindest von Zeit zu Zeit durchgeführten nächsten Schritt das abgetragene Kupfer durch Elektrolyse mit einer Platinanode oder platinierten Anode aus der Lösung metallisch abgeschieden wird, in einem dritten Schritt die Phosphorsäure durch anodische Oxidation zu Peroxophosphorsäure aufoxidiert wird und anschließend die so neu gebildete Peroxophosphorsäure als Oxidationsmittel in einem neuerlichen ersten Schritt verwendet wird und so fort.

6. Verfahren nach einem der vorhergehenden Ansprüche, dadurch **gekennzeichnet**, daß der Anfangsgehalt der Phosphorsäure 10 bis 30% beträgt.

7. Verfahren nach einem der vorhergehenden Ansprüche,
dadurch **gekennzeichnet**,
daß das Abtragen bei einer Temperatur von 40 bis 50°C durchgeführt wird.

8. Verfahren nach einem der vorhergehenden Ansprüche,
dadurch **gekennzeichnet**,
daß das Verfahren zum Anätzen von Leiterplatten verwendet wird, sogenanntes Mikroätzen.

## Claims

1. Method of stripping copper from tin plated or tin/lead plated circuit boards, in which the copper to be stripped is oxidised with an oxidation agent, and the copper oxide is separated by a phosphoric acid solution, characterized in that peroxophosphoric acid is used as oxidation agent and is subsequently delivered in that at least a part of the phosphoric acid in the etching solution is converted into peroxophosphoric acid by anodic oxidation, at least from time to time.

2. Method in accordance with claim 1, characterized in that that metallic copper is recovered by electrolysis from the stripping solution.

3. Method in accordance with claim 2, characterized in that an inert anode is used for the electrolysis of copper.

4. Method in accordance with claim 3, characterized in that the electrolysis is carried out at a current density between 0.5 and 4 A/cm$^2$.

5. Method in accordance with one of the preceding claims, characterized in that a cyclic process is carried out, in which, in a first step, the copper to be stripped is treated with a solution of peroxophosphoric acid, phosphoric acid of the oxidation stage +V and water, in a next step, which is carried out at least from time to time, the stripped copper is deposited metallically out of the solution by electrolysis with a platinum anode or a platinised anode, in a third step the phosphoric acid is oxidated by anodic oxidation to peroxophosphoric acid, and the peroxophosphoric acid, which is newly formed in this way, is subsequently used as an oxidation agent in a new first step and so on.

6. Method in accordance with one of the preceding claims, characterized in that the initial content of the phosphoric acid amounts to 10 to 30 %.

7. Method in accordance with one of the preceding claims, characterized in that the stripping is carried out at a temperature of 40 to 50°C.

8. Method in accordance with one of the preceding claims, characterized in that the method is used for the slight etching of circuit boards, so called micro-etching.

## Revendications

1. Procédé de décapage de cuivre de cartes imprimées plaquées d'étain ou d'alliage étain/plomb, dans lequel le cuivre à décaper est oxydé avec un agent d'oxydation et l'oxyde de cuivre est détaché par une solution d'acide phosphorique, caractérisé en ce que l'on utilise de l'acide peroxophosphorique en tant qu'agent d'oxydation et on le fournit en succession par le fait qu'au moins de temps à autre au moins une partie de l'acide phosphorique dans la solution d'attaque chimique est transformée en acide peroxophosphorique par oxydation anodique.

2. Procédé selon la revendication 1, caractérisé en ce que l'on récupère du cuivre métallique par électrolyse à partir de la solution de décapage.

3. Procédé selon la revendication 2, caractérisé en ce que l'on utilise une anode inerte pour l'électrolyse du cuivre.

4. Procédé selon la revendication 3, caractérisé en ce que l'électrolyse est effectuée avec une densité de courant entre 0,5 et 4 A/cm$^2$.

5. Procédé selon l'une quelconque des revendications précédentes, caractérisé en ce que l'on exécute un processus cyclique, dans lequel le cuivre à décaper est traité dans une première opération avec une solution d'acide peroxophosphorique, d'acide phosphorique de l'étape d'oxydation +V, et d'eau ; dans lequel le cuivre décapé est séparé par voie métallique hors de la solution par électrolyse avec une anode de platine ou une anode platinée dans une opération effectuée ensuite du moins de temps à autre ; dans lequel l'acide phosphorique est oxydé par oxydation anodique en acide peroxophosphorique dans une troisième opération ; et ensuite l'acide peroxophosphorique ainsi nouvellement formé est utilisé en tant qu'agent d'oxydation dans une nouvelle première opération, et ainsi de suite.

6. Procédé selon l'une quelconque des revendications précédentes, caractérisé en ce que la teneur initiale en acide phosphorique est de 10 à 30 %.

7. Procédé selon l'une quelconque des revendications précédentes, caractérisé en ce que le décapage est effectué à une température de 40 à 50°C.

8. Procédé selon l'une quelconque des revendications précédentes, caractérisé en ce que le procédé est appliqué pour l'attaque de cartes imprimées, dite "micro-attaque".

Fig.1

a)

b)

c)

d)

e)

f)

g)

h)

i)

j)

k)

l)